# EUROPEAN PATENT APPLICATION

(11) **EP 3 754 952 A1**
(43) Date of publication of application: **23.12.2020**
(21) Application number: 18906317.5
(22) Date of filing: 14.03.2018
(51) Int. Cl.: H04M 1/02, B22D 17/00, B22D 19/04

(54) **MOBILE TERMINAL INCLUDING METAL CASE AND METHOD FOR MANUFACTURING METAL CASE**

(30) Priority: 14.02.2018 KR 20180018755
(71) Applicant: LG Electronics Inc., 07336 SEOUL (KR)
(72) Inventor: LIM, Cheolho, Seoul 06772 (KR); KIM, Donghyun, Seoul 06772 (KR); KIM, Mooyoung, Seoul 06772 (KR); PARK, Kyungjune, Seoul 06772 (KR); BAE, Sanghyun, Seoul 06772 (KR); SIM, Jinwoo, Seoul 06772 (KR); CHOI, Myungsu, Seoul 06772 (KR); HONG, Sukho, Seoul 06772 (KR)
(74) Representative: Mooser, Sebastian Thomas
(86) International application number: PCT/KR2018/002967
(87) International publication number: WO 2019/160190

(57) **Abstract**

The present invention relates to a mobile terminal including a metal case, and a method for manufacturing a metal case consisting of a side frame and a bottom frame. The present invention provides a mobile terminal comprising: a terminal body including a display unit disposed on one side thereof and an antenna; and a metal case which forms the exterior of the terminal body and supports the inside of the terminal body, wherein the metal case may include an annular side frame constituting a side surface of the terminal body and a bottom frame coupled to the side frame and supporting the display unit and including a plurality of holes, the side frame having a coupling portion engaged with the bottom frame formed on an inner side surface.

## Description

### TECHNICAL FIELD

The present disclosure relates to a mobile terminal including a metal case and a method for manufacturing a metal case having a side frame and a bottom frame.

### BACKGROUND ART

Terminals may be divided into mobile/portable terminals and stationary terminals according to mobility. Also, the mobile terminals may be classified into handheld types and vehicle mount types according to whether or not a user can directly carry.

The terminal has various functions according to development of technologies. For example, a mobile terminal can be allowed to capture still images or moving images, play music or video files, play games, receive broadcast and the like, so as to be implemented as an integrated multimedia player. Efforts are ongoing to support and increase the functionality of terminals. Such efforts include software improvements, as well as changes and improvements in the structural components.

Recently, a terminal device including a metal case has been developed to give a high-quality or luxurious appearance. However, the metal case has drawbacks, such as heavy weight, and a complicated manufacturing process for forming a plurality of holes and ribs. In addition, when an antenna radiator (or emitter) is formed using the metal case, an antenna quality is greatly affected or reduced by a shape of the case itself and noise generated between internal electronic components.

Conventionally, CNC processing or machining is used to manufacture a metal case. CNC processing is advantageous in terms of easy shape realization. However, when a shape or material of a product to be manufactured is changed, a new process is required. In addition, the CNC processing may not be performed on a material that is difficult to cut. Further, as for the CNC processing, the rate of material loss is high, which may lead to an increase in manufacturing costs. Thus, various metal case manufacturing methods have been developed to compensate or address these problems of the CNC processing.

### DISCLOSURE

### TECHNICAL PROBLEM

An aspect of the present disclosure is to provide a metal case suitable for a lightweight mobile terminal.

Another aspect of the present discourse is to provide a metal case capable of maximizing a heat dissipation effect.

Still another aspect of the present disclosure is to provide a manufacturing method capable of manufacturing a metal case by assembling two or more parts together.

### TECHNICAL SOLUTION

Embodiments disclosed herein provide a mobile terminal that may include a terminal body having a display disposed on one surface thereof and provided with an antenna, a metal case defining an outer appearance of the terminal body and supporting an inside of the terminal body. The metal case may include a side frame having a ring shape and defining a side surface of the terminal body, and a bottom frame coupled to the side frame, supporting the display, and having a plurality of holes. A coupling portion coupled to the bottom frame may be provided at an inner surface of the side frame.

In one embodiment, the side frame may further include an antenna-attached portion protruding from the inner surface thereof and electrically connected to the antenna.

In one embodiment, the inner surface and an outer surface of the side frame may be made of different materials.

In one embodiment, the side frame may include a first metal layer defining the outer surface thereof and a second metal layer defining the inner surface thereof and made of a different material from the first metal layer.

In one embodiment, the antenna-attached portion may protrude from the second metal layer and be made of the same material as the second metal layer.

In one embodiment, the coupling portion may protrude from the second metal layer and be made of the same material as the second metal layer.

In one embodiment, the bottom frame may be made of the same material as the second metal layer.

In one embodiment, the first metal layer may be made of any one of titanium, copper and stainless steel, and the second metal layer may be made of any one of aluminum and magnesium.

Embodiments disclosed herein also provide a method for manufacturing a metal case, the method may include forming a side frame by providing a coupling portion and an antenna-attached portion at an inner surface of a ring-shaped raw material made of a metal or alloy, forming a bottom frame by coupling a metal sheet to the coupling portion, and forming a plurality of holes by cutting the bottom frame. The side frame and the bottom frame may be made of different materials.

### ADVANTAGEOUS EFFECTS

According to embodiments of the present disclosure, as a metal case is produced by assembling a side frame and a bottom frame together, the amount of raw material loss may be reduced compared to CNC processing. In addition, the side frame and the bottom frame are made of different metals, thereby providing the metal frame having both advantages of each metal.

Further, as CNC processing is selectively applied only to an inner surface of the side frame and the bottom frame, a metal easy to process is used for the inner surface of the side frame and the bottom frame, thereby enabling easier processing of the metal case.

### BRIEF DESCRIPTION OF THE DRAWINGS

FIG. 1A is a block diagram of a mobile terminal in accordance with one embodiment of the present disclosure.
FIGS. 1B and 1C are diagrams of a mobile terminal according to one embodiment of the present disclosure, viewed from different directions.
FIG. 2A is a perspective view of a metal case according to the present disclosure.
FIG. 2B is a cross-sectional view taken along line "A-A" of FIG. 2A.
FIG. 2C is a cross-sectional view taken along line "B-B" of FIG. 2A.
FIG. 3A is a cross-sectional view taken along line "A-A", illustrating a metal case provided with a side frame having a plurality of layers and having the same appearance as the metal case in FIG. 2A.
FIG. 3B is a cross-sectional view taken along line "B-B" of the metal case in FIG. 3A.
FIG. 4A is a schematic view illustrating a method for manufacturing a metal case according to the present disclosure.
FIG. 4B is a cross-sectional view taken along line "C-C" of FIG. 4A.
FIG. 5A is a schematic view illustrating a method for manufacturing a metal case from a raw material of clad metal.
FIG. 5B is a cross-sectional view taken along line "D-D" of FIG. 5A.
FIG. 6 is a schematic view illustrating a method for manufacturing a raw material having a ring shape from a metal sheet.

### BEST MODE FOR CARRYING OUT EMBODIMENTS

Description will now be given in detail according to exemplary embodiments disclosed herein, with reference to the accompanying drawings. For the sake of brief description with reference to the drawings, the same or equivalent components may be provided with the same or similar reference numbers, and description thereof will not be repeated. In general, a suffix such as "module" and "unit" may be used to refer to elements or components. Use of such a suffix herein is merely intended to facilitate description of the specification, and the suffix itself is not intended to give any special meaning or function. In describing the present disclosure, if a detailed explanation for a related known function or construction is considered to unnecessarily divert the main point of the present disclosure, such explanation has been omitted but would be understood by those skilled in the art. The accompanying drawings are used to help easily understand the technical idea of the present disclosure and it should be understood that the idea of the present disclosure is not limited by the accompanying drawings.

It will be understood that when an element such as a layer, area or substrate is referred to as being "on" another element, it can be directly on the element, or one or more intervening elements may also be present.

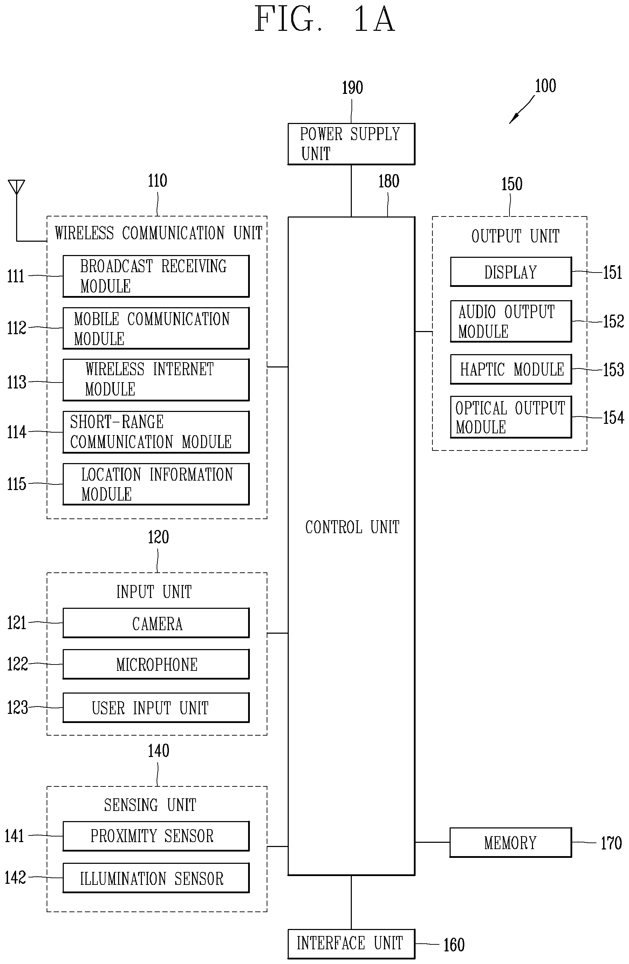

FIG. 1A is a block diagram illustrating a mobile terminal in accordance with one exemplary embodiment of the present disclosure.

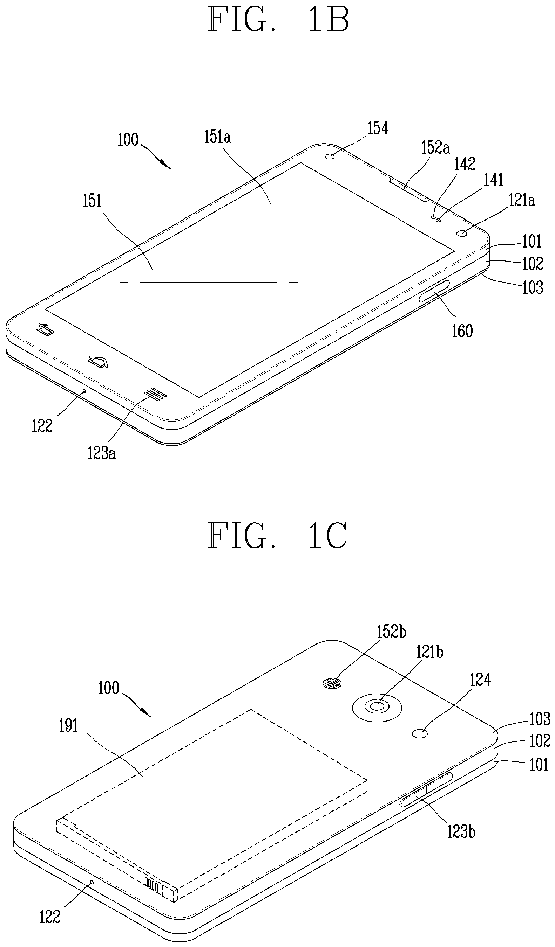

The mobile terminal 100 may be shown having components such as a wireless communication unit 110, an input unit 120, a sensing unit 140, an output unit 150, an interface unit 160, a memory 170, a controller (or control unit) 180, and a power supply unit 190. FIG. 1 shows the mobile terminal 100 having various components, but it may be understood that implementing all of the illustrated components is not a requirement. Greater or fewer components may alternatively be implemented.

In more detail, the wireless communication unit 110 may typically include one or more modules which permit communications such as wireless communications between the mobile terminal 100 and a wireless communication system, communications between the mobile terminal 100 and another mobile terminal, or communications between the mobile terminal 100 and an external server. Further, the wireless communication unit 110 may typically include one or more modules which connect the mobile terminal 100 to one or more networks.

The wireless communication unit 110 may include one or more of a broadcast receiving module 111, a mobile communication module 112, a wireless Internet module 113, a short-range communication module 114, and a location information module 115.

The input unit 120 may include a camera 121 or an image input unit for obtaining images or video, a microphone 122, which is one type of audio input device for inputting an audio signal, and a user input unit 123 (e.g., a touch key, a mechanical key, and the like) for allowing a user to input information. Data (e.g., audio, video, image, and the like) may be obtained by the input unit 120 and may be analyzed and processed according to user commands.

The sensing unit 140 may typically be implemented using one or more sensors configured to sense internal information of the mobile terminal 100, the surrounding environment of the mobile terminal 100, user information, and the like. For example, the sensing unit 140 may include at least one of a proximity sensor 141, an illumination sensor 142, a touch sensor, an acceleration sensor, a magnetic sensor, a G-sensor, a gyroscope sensor, a motion sensor, an RGB sensor, an infrared (IR) sensor, a finger scan sensor, a ultrasonic sensor, an optical sensor (e.g., camera 121), a microphone 122, a battery gauge, an environment sensor (e.g., a barometer, a hygrometer, a thermometer, a radiation detection sensor, a thermal sensor, and a gas sensor, among others), and a chemical sensor (e.g., an electronic nose, a health care sensor, a biometric sensor, and the like). The mobile terminal disclosed herein may be configured to utilize information obtained from one or more sensors of the sensing unit 140, and combinations thereof.

The output unit 150 may typically be configured to output various types of information, such as audio, video, tactile output, and the like. The output unit 150 may be shown having at least one of a display (or display unit) 151, an audio output module 152, a haptic module 153, and an optical output module 154. The display 151 may have an inter-layered structure or an integrated structure with a touch sensor in order to implement a touch screen. The touch screen may function as the user input unit 123 which provides an input interface between the mobile terminal 100 and the user and simultaneously provide an output interface between the mobile terminal 100 and a user.

The interface unit 160 serves as an interface with various types of external devices that are coupled to the mobile terminal 100. The interface unit 160, for example, may include any of wired or wireless ports, external power supply ports, wired or wireless data ports, memory card ports, ports for connecting a device having an identification module, audio input/output (I/O) ports, video I/O ports, earphone ports, and the like. In some implementations, the mobile terminal 100 may perform assorted control functions associated with a connected external device, in response to the external device being connected to the interface unit 160.

The memory 170 is typically implemented to store data to support various functions or features of the mobile terminal 100. For instance, the memory 170 may be configured to store application programs executed in the mobile terminal 100, data or instructions for operations of the mobile terminal 100, and the like. Some of these application programs may be downloaded from an external server via wireless communication. Other application programs may be installed within the mobile terminal 100 at time of manufacturing or shipping, which is typically the case for basic functions of the mobile terminal 100 (e.g., receiving a call, placing a call, receiving a message, sending a message, and the like). It is common for application programs to be stored in the memory 170, installed in the mobile terminal 100, and executed by the controller 180 to perform an operation (or function) for the mobile terminal 100.

The controller 180 typically functions to control an overall operation of the mobile terminal 100, in addition to the operations associated with the application programs. The controller 180 may provide or process information or functions appropriate for a user by processing signals, data, information and the like, which are input or output by the aforementioned various components, or activating application programs stored in the memory 170.

Also, the controller 180 may control at least some of the components illustrated in FIG. 1A, to execute an application program that have been stored in the memory 170. In addition, the controller 180 may control at least two of those components included in the mobile terminal 100 to activate the application program.

The power supply unit 190 may be configured to receive external power or provide internal power in order to supply appropriate power required for operating elements and components included in the wearable device 100, under the control of the controller 180. The power supply unit 190 may include a battery, and the battery may be configured as an embedded battery or a detachable battery.

At least part of the components may cooperatively operate to implement an operation, a control or a control method of the mobile terminal 100 according to various embodiments disclosed herein. Also, the operation, the control or the control method of the mobile terminal 100 may be implemented on electronic device by an activation of at least one application program stored in the memory 170.

Hereinafter, description will be given in more detail of the aforementioned components with reference to FIG. 1, prior to describing various embodiments implemented through the mobile terminal 100.

First, regarding the wireless communication unit 110, the broadcast receiving module 111 is typically configured to receive a broadcast signal and/or broadcast associated information from an external broadcast managing entity via a broadcast channel. The broadcast channel may include a satellite channel, a terrestrial channel, or both. In some implementations, two or more broadcast receiving modules 111 may be utilized to facilitate simultaneous reception of two or more broadcast channels, or to support switching among broadcast channels.

The mobile communication module 112 may transmit and/or receive wireless signals to and from one or more network entities. Typical examples of a network entity include a base station, an external mobile terminal, a server, and the like. Such network entities form part of a mobile communication network, which is constructed according to technical standards or communication methods for mobile communications (e.g., Global System for Mobile Communication (GSM), Code Division Multi Access (CDMA), CDMA2000 (Code Division Multi Access 2000), EV-DO (Enhanced Voice-Data Optimized or Enhanced Voice-Data Only), Wideband CDMA (WCDMA), High Speed Downlink Packet access (HSDPA), HSUPA(High Speed Uplink Packet Access), Long Term Evolution (LTE), LTE-A (Long Term Evolution-Advanced), and the like).

The wireless signal may include various types of data depending on a voice call signal, a video call signal, or a text/multimedia message transmission/reception.

The wireless Internet module 113 refers to a module for wireless Internet access. This module may be internally or externally coupled to the mobile terminal 100. The wireless Internet module 113 may transmit and/or receive wireless signals via communication networks according to wireless Internet technologies.

Examples of such wireless Internet access include Wireless LAN (WLAN), Wireless Fidelity (Wi-Fi), Wi-Fi Direct, Digital Living Network Alliance (DLNA), Wireless Broadband (WiBro), Worldwide Interoperability for Microwave Access (WiMAX), High Speed Downlink Packet Access (HSDPA), High Speed Uplink Packet Access (HSUPA), Long Term Evolution (LTE), LTE-advanced (LTE-A), and the like. The wireless Internet module 113 may transmit/receive data according to one or more of such wireless Internet technologies, and other Internet technologies as well.

When the wireless Internet access is implemented according to, for example, WiBro, HSDPA, HSUPA, GSM, CDMA, WCDMA, LTE, LTE-A, and the like, as part of a mobile communication network, the wireless Internet module 113 performs such wireless Internet access. As such, the Internet module 113 may cooperate with, or function as, the mobile communication module 112.

The short-range communication module 114 is configured to facilitate short-range communications. Suitable technologies for implementing such short-range communications include BLUETOOTH™, Radio Frequency IDentification (RFID), Infrared Data Association (IrDA), Ultra-WideBand (UWB), ZigBee, Near Field Communication (NFC), Wireless-Fidelity (Wi-Fi), Wi-Fi Direct, Wireless USB (Wireless Universal Serial Bus), and the like. The short-range communication module 114 in general supports wireless communications between the mobile terminal 100 and a wireless communication system, communications between the mobile terminal 100 and another mobile terminal 100, or communications between the mobile terminal and a network where another mobile terminal 100 (or an external server) is located, via wireless area networks. One example of the wireless area networks is a wireless personal area network.

Here, another electronic device may be a wearable device, for example, a smart watch, a smart glass, or a head mounted display (HMD), which is able to exchange data with the mobile terminal 100 (or otherwise cooperate with the mobile terminal 100). The short-range communication module 114 may sense or recognize the wearable device, and permit communications between the wearable device and the mobile terminal 100. In addition, when the sensed wearable device is a device which is authenticated to communicate with the mobile terminal 100, the controller 180, for example, may cause transmission of at least part of data processed in the mobile terminal 100 to the wearable device via the short-range communication module 114. Hence, a user of the wearable device may use the data processed in the mobile terminal 100 on the wearable device. For example, when a call is received in the mobile terminal 100, the user may answer the call using the wearable device. Also, when a message is received in the mobile terminal 100, the user can check the received message using the wearable device.

The location information module 115 is generally configured to detect, calculate, derive or otherwise identify a position (or current position) of the mobile terminal 100. As an example, the location information module 115 includes a Global Position System (GPS) module, a Wi-Fi module, or both. For example, when the mobile terminal 100 uses a GPS module, a position of the mobile terminal 100 may be acquired using a signal sent from a GPS satellite. As another example, when the mobile terminal 100 uses the Wi-Fi module, a position of the mobile terminal 100 may be acquired based on information related to a wireless access point (AP) which transmits or receives a wireless signal to or from the Wi-Fi module. If desired, the location information module 115 may alternatively or additionally perform a function of any of the other modules of the wireless communication unit 110 to obtain data related to the position of the mobile terminal 100. The location information module 115 is a module used for acquiring the position (or the current position) of the mobile terminal 100, and may not be limited to a module for directly calculating or acquiring the position of the electronic device.

Next, the input unit 120 is for inputting image information (or signal), audio information (or signal), data, or information input from a user. For inputting image information, the mobile terminal 100 may be provided with a plurality of cameras 121. Such cameras 121 may process image frames of still pictures or video obtained by image sensors in a video or image capture mode. The processed image frames may be displayed on the display 151 or stored in the memory 170. Meanwhile, the cameras 121 provided in the mobile terminal 100 may be arranged in a matrix configuration to permit a plurality of image information having various angles or focal points to be input to the mobile terminal 100. Also, the cameras 121 may be located in a stereoscopic arrangement to acquire left and right images for implementing a stereoscopic image.

The microphone 122 processes an external audio signal into electric audio (sound) data. The processed audio data may be processed in various manners according to a function being executed in the mobile terminal 100. If desired, the microphone 122 may include assorted noise removing algorithms to remove unwanted noise generated in the course of receiving the external audio signal.

The user input unit 123 is a component that permits input by a user. Such user input may enable the controller 180 to control operation of the mobile terminal 100. The user input unit 123 may include one or more of a mechanical input element (e.g., a mechanical key, a button located on a front and/or rear surface or a side surface of the mobile terminal 100, a dome switch, a jog wheel, a jog switch, and the like), or a touch-sensitive input element, among others. As one example, the touch-sensitive input element may be a virtual key, a soft key or a visual key, which is displayed on a touch screen through software processing, or a touch key which is located on the electronic device at a location that is other than the touch screen. Meanwhile, the virtual key or the visual key may be displayed on the touch screen in various forms, for example, graphic, text, icon, video, or a combination thereof.

The sensing unit 140 is generally configured to sense one or more of internal information of the mobile terminal 100, surrounding environment information of the mobile terminal 100, user information, or the like, and generates a corresponding sensing signal. The controller 180 generally cooperates with the sending unit 140 to control operations of the mobile terminal 100, or to perform data processing, a function or an operation associated with an application program installed in the mobile terminal 100 based on the sensing signal. The sensing unit 140 may be implemented using any of a variety of sensors, some of which will now be described in more detail.

The proximity sensor 141 refers to a sensor to sense presence or absence of an object approaching a surface, or an object located near a surface, by using an electromagnetic field, infrared rays, or the like without a mechanical contact. The proximity sensor 141 may be arranged at an inner region of the mobile terminal 100 covered by the touch screen, or near the touch screen.

The proximity sensor 141, for example, may include any of a transmissive type photoelectric sensor, a direct reflective type photoelectric sensor, a mirror reflective type photoelectric sensor, a high-frequency oscillation proximity sensor, a capacitance type proximity sensor, a magnetic type proximity sensor, an infrared rays proximity sensor, and the like. When the touch screen is implemented as a capacitance type, the proximity sensor 141 may sense proximity of a pointer relative to the touch screen by changes of an electromagnetic field, which is responsive to an approach of an object with conductivity. In this case, the touch screen (or touch sensor) may be categorized as a proximity sensor.

The term "proximity touch" will often be referred to herein to denote the scenario in which a pointer is positioned to be proximate to the touch screen without contacting the touch screen. The term "contact touch" will often be referred to herein to denote the scenario in which a pointer makes physical contact with the touch screen. For the position corresponding to the proximity touch of the pointer relative to the touch screen, such position will correspond to a position where the pointer is perpendicular to the touch screen. The proximity sensor 141 may sense proximity touch, and proximity touch patterns (e.g., distance, direction, speed, time, position, moving status, and the like). In general, the controller 180 may process data (or information) corresponding to proximity touches and proximity touch patterns sensed by the proximity sensor 141, and cause visual information corresponding to the processed data to be output on the touch screen. In addition, the controller 180 may control the mobile terminal 100 to execute different operations or process different data (or information) according to whether a touch with respect to a point on the touch screen is either a proximity touch or a contact touch.

A touch sensor senses a touch (or touch input) applied to the touch screen (or the display 151) using any of a variety of touch methods. Examples of such touch methods include a resistive type, a capacitive type, an infrared type, and a magnetic field type, among others.

As one example, the touch sensor may be configured to convert changes of pressure applied to a specific part (or portion) of the display 151, or convert capacitance occurring at a specific part of the touch screen, into electric input signals. The touch sensor may also be configured to sense not only a touched position and a touched area, but also touch pressure and/or touch capacitance. A touch object is generally used to apply a touch input to the touch sensor. Examples of typical touch objects include a finger, a touch pen, a stylus pen, a pointer, or the like.

When a touch input is sensed by a touch sensor, corresponding signals may be transmitted to a touch controller. The touch controller may process the received signals, and then transmit corresponding data to the controller 180. Accordingly, the controller 180 may sense which area of the display 151 has been touched. Here, the touch controller may be a component separate from the controller 180, or the controller 180 itself.

Meanwhile, the controller 180 may execute the same or different controls according to a type of touch object that touches the touch screen or a touch key provided in addition to the touch screen. Whether to execute the same or different control according to the object which provides a touch input may be decided based on a current operating state of the mobile terminal 100 or a currently executed application program, for example.

The touch sensor and the proximity sensor may be implemented individually, or in combination, to sense various types of touches. Such touches include a short (or tap) touch, a long touch, a multi-touch, a drag touch, a flick touch, a pinch-in touch, a pinch-out touch, a swipe touch, a hovering touch, and the like.

If desired, an ultrasonic sensor may be implemented to recognize location information related to a touch object using ultrasonic waves. The controller 180, for example, may calculate a position of a wave generation source based on information sensed by an illumination sensor and a plurality of ultrasonic sensors. Since light is much faster than ultrasonic waves, the time for which the light reaches the optical sensor is much shorter than the time for which the ultrasonic wave reaches the ultrasonic sensor. The position of the wave generation source may be calculated using this fact. For instance, the position of the wave generation source may be calculated using the time difference from the time that the ultrasonic wave reaches the sensor based on the light as a reference signal.

The camera 121, which has been depicted as a component of the input unit 120, typically includes at least one of a camera sensor (CCD, CMOS etc.), a photo sensor (or image sensors), and a laser sensor.

Implementing the camera 121 with a laser sensor may allow detection of a touch of a physical object with respect to a 3D stereoscopic image. The photo sensor may be laminated on, or overlapped with, the display device. The photo sensor may be configured to scan movement of the object in vicinity of the touch screen. In more detail, the photo sensor may include photo diodes and transistors (TRs) at rows and columns to scan content received at the photo sensor using an electrical signal that changes according to the quantity of applied light. Namely, the photo sensor may calculate the coordinates of the physical object according to variation of light to thus obtain location information of the physical object.

The display 151 is generally configured to output information processed in the mobile terminal 100. For example, the display 151 may display execution screen information of an application program executing at the mobile terminal 100 or user interface (Ul) and graphic user interface (GUI) information in response to the execution screen information.

Also, the display 151 may be implemented as a stereoscopic display for displaying stereoscopic images.

A typical stereoscopic display may employ a stereoscopic display scheme such as a stereoscopic scheme (a glass scheme), an auto-stereoscopic scheme (glassless scheme), a projection scheme (holographic scheme), or the like.

The audio output module 152 may receive audio data from the wireless communication unit 110 or output audio data stored in the memory 170 during modes such as a signal reception mode, a call mode, a record mode, a voice recognition mode, a broadcast reception mode, and the like. The audio output module 152 may provide audible output related to a particular function (e.g., a call signal reception sound, a message reception sound, etc.) performed by the mobile terminal 100. The audio output module 152 may also be implemented as a receiver, a speaker, a buzzer, or the like.

A haptic module 153 may be configured to generate various tactile effects that a user feels, perceives, or otherwise experiences. A typical example of a tactile effect generated by the haptic module 153 is vibration. The strength, pattern and the like of the vibration generated by the haptic module 153 may be controlled by user selection or setting by the controller. For example, the haptic module 153 may output different vibrations in a combining manner or a sequential manner.

Besides vibration, the haptic module 153 may generate various other tactile effects, including an effect by stimulation such as a pin arrangement vertically moving to contact skin, a spray force or suction force of air through a jet orifice or a suction opening, a touch to the skin, a contact of an electrode, electrostatic force, an effect by reproducing the sense of cold and warmth using an element that can absorb or generate heat, and the like.

The haptic module 153 may also be implemented to allow the user to feel a tactile effect through a muscle sensation such as the user's fingers or arm, as well as transferring the tactile effect through direct contact. Two or more haptic modules 153 may be provided according to the particular configuration of the mobile terminal 100.

An optical output module 154 may output a signal for indicating an event generation using light of a light source of the mobile terminal 100. Examples of events generated in the mobile terminal 100 may include message reception, call signal reception, a missed call, an alarm, a schedule notice, email reception, information reception through an application, and the like.

A signal output by the optical output module 154 may be implemented in such a manner that the mobile terminal 100 emits monochromatic light or light with a plurality of colors to a front or rear surface. The signal output may be terminated as the mobile terminal 100 senses that a user has checked the generated event, for example.

The interface unit 160 serves as an interface for external devices to be connected with the mobile terminal 100. For example, the interface unit 160 may receive data transmitted from an external device, receive power to transfer to elements and components within the mobile terminal 100, or transmit internal data of the mobile terminal 100 to such external device. The interface unit 160 may include wired or wireless headset ports, external power supply ports, wired or wireless data ports, memory card ports, ports for connecting a device having an identification module, audio input/output (I/O) ports, video I/O ports, earphone ports, or the like.

The identification module may be a chip that stores various information for authenticating authority of using the mobile terminal 100 and may include a user identity module (UIM), a subscriber identity module (SIM), a universal subscriber identity module (USIM), and the like. In addition, the device having the identification module (also referred to herein as an "identifying device") may take the form of a smart card. Accordingly, the identifying device may be connected to the mobile terminal 100 via the interface unit 160.

When the mobile terminal 100 is connected with an external cradle, the interface unit 160 may serve as a passage to allow power from the cradle to be supplied to the mobile terminal 100 or may serve as a passage to allow various command signals input by the user from the cradle to be transferred to the mobile terminal therethrough. Various command signals or power input from the cradle may operate as signals for recognizing that the mobile terminal is properly mounted on the cradle.

The memory 170 may store programs to support operations of the controller 180 and store input/output data (e.g., phonebook, messages, still images, videos, etc.). The memory 170 may store data related to various patterns of vibrations and audio which are output in response to touch inputs on the touch screen.

The memory 170 may include one or more types of storage mediums including a flash memory type, a hard disk type, a solid state disk (SSD) type, a silicon disk drive (SDD) type, a multimedia card micro type, a card-type memory (e.g., SD or DX memory, etc.), a Random Access Memory (RAM), a Static Random Access Memory (SRAM), a Read-Only Memory (ROM), an Electrically Erasable Programmable Read-Only Memory (EEPROM), a Programmable Read-Only memory (PROM), a magnetic memory, a magnetic disk, an optical disk, and the like. The mobile terminal 100 may also be operated in relation to a network storage device that performs the storage function of the memory 170 over a network, such as the Internet.

The controller 180 may typically control operations related to application programs and the general operations of the mobile terminal 100. For example, the controller 180 may set or release a lock state for restricting a user from inputting a control command with respect to applications when a status of the mobile terminal 100 meets a preset condition.

The controller 180 may also perform the controlling and processing associated with voice calls, data communications, video calls, and the like, or perform pattern recognition processing to recognize a handwriting input or a picture drawing input performed on the touch screen as characters or images, respectively. In addition, the controller 180 may control one or a combination of those components in order to implement various exemplary embodiments disclosed herein.

The power supply unit 190 receives external power or provides internal power to supply the appropriate power required for operating respective elements and components included in the portable electronic device 100 under the control of the controller 180. The power supply unit 190 may include a battery which is typically rechargeable, or be detachably coupled to the terminal body for (re)charging.

The power supply unit 190 may include a connection port. The connection port may be configured as one example of the interface unit 160 to which an external charger for supplying power to recharge the battery is electrically connected.

As another example, the power supply unit 190 may be configured to recharge the battery in a wireless manner without use of the connection port. In this example, the power supply unit 190 may receive power, transferred from an external wireless power transmitter, using at least one of an inductive coupling method which is based on magnetic induction or a magnetic resonance coupling method which is based on electromagnetic resonance.

Various embodiments described herein may be implemented in a computer-readable medium, a machine-readable medium, or similar medium using, for example, software, hardware, or any combination thereof.

Hereinafter, description will be given of a structure of the mobile terminal 100 according to the one embodiment of the present disclosure illustrated in FIG. 1A, or a terminal having those components, with reference to FIG. 1C.

Referring to FIGS. 1B and 1C, the disclosed mobile terminal 100 includes a bar-like terminal body. However, the mobile terminal 100 may alternatively be implemented in any of a variety of different configurations. Examples of such configurations include a watch type, clip-type, glasses-type, or a folder-type, flip-type, slide-type, swing-type, and swivel-type in which two and more bodies are combined with each other in a relatively movable manner, and combinations thereof. Discussion herein will often relate to a particular type of mobile terminal. However, such teachings with regard to a particular type of mobile terminal will generally be applied to other types of mobile terminals as well.

Here, considering the mobile terminal 100 as at least one assembly, the terminal body may be understood as a conception referring to the assembly.

The mobile terminal 100 will generally include a case (e.g., frame, housing, cover, and the like) defining the appearance of the terminal. In this embodiment, the case is formed using a front case 101 and a rear case 102. Various electronic components are interposed into a space formed between the front case 101 and the rear case 102. At least one middle case may be additionally positioned between the front case 101 and the rear case 102.

The display 151 is shown located on the front side of the terminal body to output information. As illustrated, a window 151a of the display 151 may be mounted to the front case 101 to form the front surface of the terminal body together with the front case 101.

In some implementations, electronic components may also be mounted to the rear case 102. Examples of such electronic components include a detachable battery 191, an identification module, a memory card, and the like. In this case, a rear cover 103 is shown covering the electronic components, and this cover may be detachably coupled to the rear case 102. Therefore, when the rear cover 300 is detached from the rear case 102, the electronic components mounted on the rear case 102 are exposed to the outside.

As illustrated, when the rear cover 300 is coupled to the rear case 102, a side surface of the rear case 102 may partially be exposed. In some cases, upon the coupling, the rear case 102 may also be completely shielded by the rear cover 300. Meanwhile, the rear cover 300 may include an opening for externally exposing a camera 121b or an audio output module 152b.

The cases 101, 102, 103 may be formed by injection-molding synthetic resin or may be formed of a metal, for example, stainless steel (STS), aluminum (Al), titanium (Ti), or the like.

As an alternative to the example in which the plurality of cases forms an inner space for accommodating components, the mobile terminal 100 may be configured such that one case forms the inner space. In this case, a mobile terminal 100 having a uni-body is formed in such a manner that synthetic resin or metal extends from a side surface to a rear surface.

Meanwhile, the mobile terminal 100 may include a waterproofing unit (not shown) for preventing introduction of water into the terminal body. For example, the waterproofing unit may include a waterproofing member which is located between the window 151a and the front case 101, between the front case 101 and the rear case 102, or between the rear case 102 and the rear cover 300, to hermetically seal an inner space when those cases are coupled.

The mobile terminal 100 may include a display (or display unit) 151, first and second audio output module 152a and 152b, a proximity sensor 141, an illumination sensor 142, an optical output module 154, first and second cameras 121a and 121b, first and second manipulation units 123a and 123b, a microphone 122, an interface unit 160, and the like.

Hereinafter, as illustrated in FIGS. 1B and 1C, description will be given of the exemplary mobile terminal 100 in which the front surface of the terminal body is shown having the display 151, the first audio output module 152a, the proximity sensor 141, the illumination sensor 142, the optical output module 154, the first camera 121a, and the first manipulation unit 123a, the side surface of the terminal body is shown having the second manipulation unit 123b, the microphone 122, and the interface unit 160, and the rear surface of the terminal body is shown having the second audio output module 152b and the second camera 121b.

However, those components may not be limited to the arrangement. Some components may be omitted or rearranged, or located on different surfaces. For example, the first manipulation unit 123a may be located on another surface of the terminal body, and the second audio output module 152b may be located on the side surface of the terminal body other than the rear surface of the terminal body.

The display 151 is generally configured to output information processed in the mobile terminal 100. For example, the display 151 may display execution screen information of an application program executing at the mobile terminal 100 or user interface (Ul) and graphic user interface (GUI) information in response to the execution screen information.

The display 151 may include at least one of a liquid crystal display (LCD), a thin film transistor-LCD (TFT LCD), an organic light-emitting diode (OLED), a flexible display, a three-dimensional (3D) display, and an e-ink display.

The display 151 may be implemented using two display devices, according to the configuration type thereof. For instance, a plurality of the displays 151 may be arranged on one side, either spaced apart from each other, or these devices may be integrated, or these devices may be arranged on different surfaces.

The display 151 may include a touch sensor that senses a touch with respect to the display 151 so as to receive a control command in a touch manner. Accordingly, when a touch is applied to the display 151, the touch sensor may sense the touch, and a controller 180 may generate a control command corresponding to the touch. Contents input in the touch manner may be characters, numbers, instructions in various modes, or a menu item that can be designated.

On the other hand, the touch sensor may be configured in a form of a film having a touch pattern and disposed between a window and a display (not illustrated) on a rear surface of the window, or may be a metal wire directly patterned on the rear surface of the window. Alternatively, the touch sensor may be formed integrally with the display. For example, the touch sensor may be disposed on a substrate of the display, or may be provided inside the display.

In this way, the display 151 may form a touch screen together with the touch sensor, and in this case, the touch screen may function as the user input unit 123 (see FIG. 1A). In some cases, the touch screen may replace at least some of functions of a first manipulation unit 123a. Hereinafter, for the sake of explanation, the display (display module) for outputting the image and the touch sensor are collectively referred to as a touch screen 151.

The first audio output module 152a may be implemented as a receiver for transmitting a call sound to a user's ear and the second audio output module 152b may be implemented as a loud speaker for outputting various alarm sounds or multimedia reproduction request sounds.

The window 151a of the display 151 may include a sound hole for emitting sounds generated from the first audio output module 152a. However, the present disclosure is not limited thereto, and the sounds may be released along an assembly gap between the structural bodies (e.g., a gap between the window 151a and the front case 101). In this case, a hole independently formed to output audio sounds may not be seen or may otherwise be hidden in terms of appearance, thereby further simplifying the appearance of the mobile terminal 100.

The optical output module 154 may be configured to output light for indicating an event generation. Examples of such events may include a message reception, a call signal reception, a missed call, an alarm, a schedule alarm, an email reception, information reception through an application, and the like. When a user has checked a generated event, the controller 180 may control the optical output module 154 to stop the light output.

The first camera 121a may process image frames such as still or moving images obtained by the image sensor in a capture mode or a video call mode. The processed image frames may then be displayed on the display 151 or stored in the memory 170.

The first and second manipulation units 123a and 123b are examples of the user input unit 123, which may be manipulated by a user to provide input to the mobile terminal 100. The first and second manipulation units 123a and 123b may also be commonly referred to as a manipulating portion. The first and second manipulation units 123a and 123b may employ any method if it is a tactile manner allowing the user to perform manipulation with a tactile feeling such as touch, push, scroll or the like. The first and second manipulation units 123a and 123b may also be manipulated through a proximity touch, a hovering touch, and the like, without a user's tactile feeling.

The drawings are illustrated on the basis that the first manipulation unit 123a is a touch key, but the present disclosure may not be necessarily limited to this. For example, the first manipulation unit 123a may be configured with a mechanical key, or a combination of a touch key and a push key.

The content received by the first and second manipulation units 123a and 123b may be set in various ways. For example, the first manipulation unit 123a may be used by the user to input a command such as menu, home key, cancel, search, or the like, and the second manipulation unit 123b may be used by the user to input a command, such as controlling a volume level being output from the first or second audio output module 152a or 152b, switching into a touch recognition mode of the display 151, or the like.

Meanwhile, as another example of the user input unit 123, a rear input unit (not shown) may be disposed on the rear surface of the terminal body. The rear input unit may be manipulated by a user to input a command for controlling an operation of the mobile terminal 100. The content input may be set in various ways. For example, the rear input unit may be used by the user to input a command, such as power on/off, start, end, scroll or the like, controlling a volume level being output from the first or second audio output module 152a or 152b, switching into a touch recognition mode of the display 151, or the like. The rear input unit may be implemented into a form allowing a touch input, a push input or a combination thereof.

The rear input unit may be disposed to overlap the display 151 of the front surface in a thickness direction of the terminal body. As one example, the rear input unit may be disposed on an upper end portion of the rear surface of the terminal body such that a user can easily manipulate it using a forefinger when the user grabs the terminal body with one hand. However, the present disclosure may not be limited to this, and the position of the rear input unit may be changeable.

When the rear input unit is disposed on the rear surface of the terminal body, a new user interface may be implemented using the rear input unit. Also, the aforementioned touch screen or the rear input unit may substitute for at least part of functions of the first manipulation unit 123a located on the front surface of the terminal body. Accordingly, when the first manipulation unit 123a is not disposed on the front surface of the terminal body, the display 151 may be implemented to have a larger screen.

Meanwhile, the mobile terminal 100 may include a finger scan sensor that scans a user's fingerprint. The controller 180 may use fingerprint information sensed by the finger scan sensor as an authentication means. The finger scan sensor may be installed in the display 151 or the user input unit 123.

The microphone 122 may be configured to receive the user's voice, other sounds, and the like. The microphone 122 may be provided at a plurality of places, and configured to receive stereo sounds.

The interface unit 160 may serve as a path allowing the mobile terminal 100 to interface with external devices. For example, the interface unit 160 may be at least one of a connection terminal for connecting to another device (e.g., an earphone, an external speaker, or the like), a port for near field communication (e.g., an Infrared DaAssociation (IrDA) port, a Bluetooth port, a wireless LAN port, and the like), or a power supply terminal for supplying power to the mobile terminal 100. The interface unit 160 may be implemented in the form of a socket for accommodating an external card, such as Subscriber Identification Module (SIM), User Identity Module (UIM), or a memory card for information storage.

The second camera 121b may be further mounted to the rear surface of the terminal body. The second camera 121b may have an image capturing direction, which is substantially opposite to the direction of the first camera unit 121a.

The second camera 121b may include a plurality of lenses arranged along at least one line. The plurality of lenses may be arranged in a matrix form. The cameras may be referred to as an 'array camera.' When the second camera 121b is implemented as the array camera, images may be captured in various manners using the plurality of lenses and images with better qualities may be obtained.

The flash 124 may be disposed adjacent to the second camera 121b. When an image of a subject is captured with the camera 121b, the flash 124 may illuminate the subject.

The second audio output module 152b may further be disposed on the terminal body. The second audio output module 152b may implement stereophonic sound functions in conjunction with the first audio output module 152a, and may be also used for implementing a speaker phone mode for call communication.

At least one antenna for wireless communication may be disposed on the terminal body. The antenna may be embedded in the terminal body or formed in the case. For example, an antenna which configures a part of the broadcast receiving module 111 (see FIG. 1A) may be retractable into the terminal body. Alternatively, an antenna may be formed in a form of film to be attached onto an inner surface of the rear cover 300 or a case including a conductive material may serve as an antenna.

The terminal body is provided with a power supply unit 190 (see FIG. 1A) for supplying power to the mobile terminal 100. The power supply unit 190 may include a batter 191 which is mounted in the terminal body or detachably coupled to an outside of the terminal body.

The battery 191 may receive power via a power cable connected to the interface unit 160. Also, the battery 191 may be (re)chargeable in a wireless manner using a wireless charger. The wireless charging may be implemented by magnetic induction or electromagnetic resonance.

On the other hand, the drawing illustrates that the rear cover 300 is coupled to the rear case 102 for shielding the battery 191, so as to prevent separation of the battery 191 and protect the battery 191 from an external impact or foreign materials. When the battery 191 is detachable from the terminal body, the rear case 300 may be detachably coupled to the rear case 102.

An accessory for protecting an appearance or assisting or extending the functions of the mobile terminal 100 may further be provided on the mobile terminal 100. As one example of the accessory, a cover or pouch for covering or accommodating at least one surface of the mobile terminal 100 may be provided. The cover or pouch may cooperate with the display 151 to extend the function of the mobile terminal 100. Another example of the accessory may be a touch pen for assisting or extending a touch input onto a touch screen.

Hereinafter, a metal case provided in the mobile terminal according to the present disclosure will be described in detail.

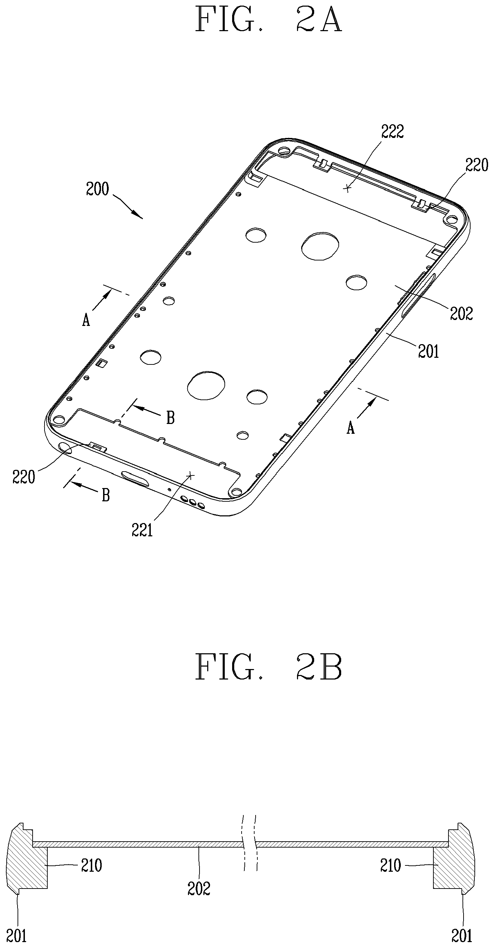

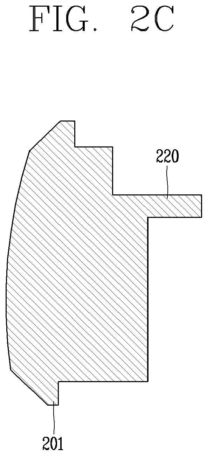

FIG. 2A is a perspective view of a metal case according to the present disclosure, FIG. 2B is a cross-sectional view taken along line "A-A" of FIG. 2A, and FIG. 2C is a cross-sectional view taken along line "B-B" of FIG. 2A.

The metal case 200 according to the present disclosure includes a side frame 201 and a bottom frame 202.

Hereinafter, the aforementioned components will be described in detail.

As illustrated, the side frame 201 defines a side (or lateral) surface of a terminal body, and has a ring (or annular) shape. The side frame 201 has an outer surface defining the side surface of the terminal body and an inner surface directed toward the inside of the terminal.

The outer surface of the side frame 201 defines the side surface of the terminal body. The outer surface of the side frame 201 may have a curved shape. In detail, the outer surface of the side frame 201 may have a different curvature depending on a position. Accordingly, aesthetics of the side surface of the mobile terminal, which is exposed to the outside, may be improved.

On the other hand, the inner surface of the side frame 201 is not necessarily formed in a curved shape since structures for supporting the components of the mobile terminal are provided thereat. A coupling portion 210 and an antenna-attached portion 220 may be provided at the inner surface of the side frame 201.

The side frame 201 is formed by processing a raw material having a ring shape. In more detail, the side frame 201 is made from a raw material (or initial form of frame) having a square ring shape with a predetermined thickness (hereinafter, "raw material). The coupling portion 210 and the antenna-attached portion 220 may be formed when processing the raw material.

The coupling portion 210 protrudes from the inner surface of the side frame 201. The coupling portion 210 may be formed by forging or cutting. When the coupling portion 210 is formed by forging, a part (or portion) of the side frame 201 may have a smaller (or thinner) thickness than the raw material, and a region (or area) where the coupling portion 210 is formed may have a greater (or thicker) thickness than the raw material.

The antenna-attached portion 220 may be formed by forging. The antenna-attached portion 220 provides electrical connection between the metal case and an antenna, so as to allow the metal case to serve as the antenna. When the antenna-attached portion 220 is formed by forging, a thickness of a region adjacent to the antenna-attached portion 220 is less (or thinner) than the raw material, and a region where the antenna-attached portion 220 is formed may have a greater (or thicker) thickness than the raw material.

Meanwhile, the bottom frame 202 is coupled to the side frame 201, supports the display, and includes a plurality of opening portions. More specifically, the bottom frame 202 is coupled to the coupling portion 210. The coupling portion 210 may be provided at each of two inner surfaces of the side frame 201 formed in a lengthwise direction, and a distance between the coupling portions 210 respectively provided at the two inner surfaces is less than a width of the bottom frame 202. This may allow the bottom frame 202 to be placed onto the two coupling portions 210.

The bottom frame 202 includes a plurality of holes 221 and 222. The holes may correspond to assembly holes for assembling a case, a printed circuit board, and the like, and openings that allow a flexible printed circuit board to be seated thereon. The holes have different sizes.

Meanwhile, the side frame 201 and the bottom frame 202 may be made of different metals. In one implementation, the side frame 201 may be made of a titanium metal, and the bottom frame 202 may be made of an aluminum metal. As the titanium metal having a relatively higher strength is exposed to the outside, strength of the metal frame may be improved. Further, as the relatively soft aluminum metal is disposed inside the terminal, a lightweight metal case may be achieved and CNC processing or machining may be performed in an easier manner. Moreover, when the bottom frame 202 is made of the aluminum metal, heat dissipation performance of the mobile terminal may be improved.

Meanwhile, the side frame 201 may be made of any one of copper and stainless steel. In addition, the bottom frame 202 may be made of a magnesium metal. The side frame 201 may be made of a metal having a high strength to protect parts inside the mobile terminal, whereas the bottom frame 202 is made of a lightweight metal to achieve a lightweight metal case, or a metal having a high thermal conductivity to improve heat dissipation performance of the metal case.

According to the present disclosure, as the metal case is formed by assembling the side frame with the bottom frame, an amount of raw material loss may be reduced compared to CNC processing. Further, in the present disclosure, the side frame and the bottom frame are made of different metals, allowing the metal frame to have both advantages of each metal.

Meanwhile, the side frame 201 may consist of two layers.

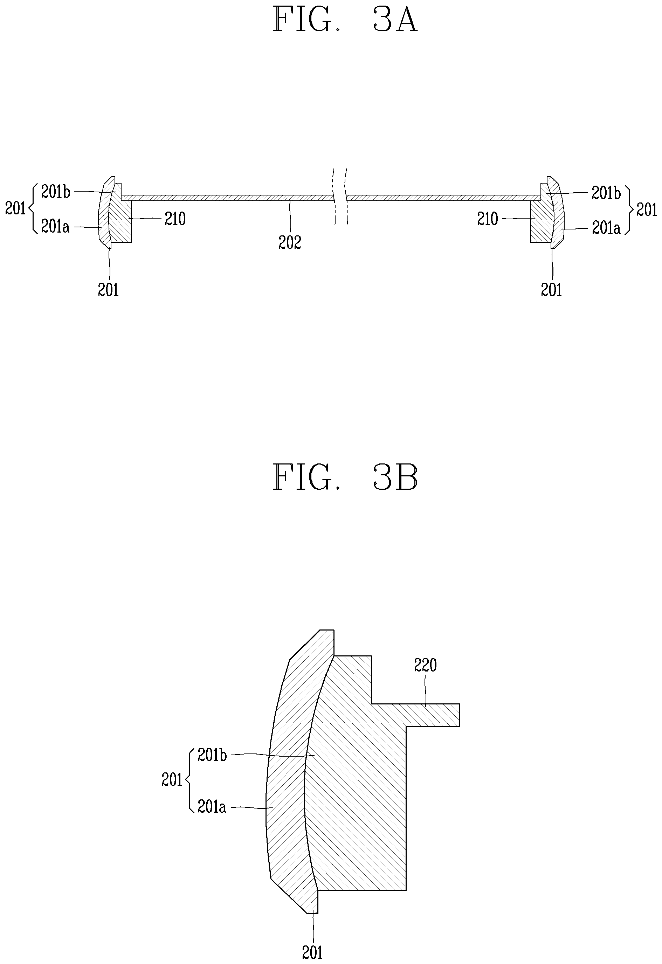

FIG. 3A is a cross-sectional view taken along line "A-A", illustrating a metal case including a plurality of layers and having the same appearance as the metal case in FIG. 2A, and FIG. 3B is a cross-sectional view taken along line "B-B" of the metal case in FIG. 3A.

As illustrated in FIGS. 3A and 3B, the outer and inner surfaces of the side frame 201 may be made of different materials. The side frame 201 may use a ring formed by processing a clad metal as a raw material.

Cladding may be achieved by stacking two or more types of metal plates and applying heat and pressure. Accordingly, the clad metal having two or more layers of different metals may have both advantages of each metal. For example, titanium and aluminum, copper and aluminum, or stainless steel and aluminum may be used for a clad metal.

When the clad metal is processed into a square ring shape, inner and outer surfaces of the square ring are made of different materials. For example, the outer surface of the square ring may be made of any one of titanium, copper and stainless steel, and the inner surface of the square ring may be made of any one of aluminum and magnesium.

When processing the square ring, the inner surface and the outer surface of the side frame 201 are made of different metals. In this specification, a metal layer defining the outer surface of the side frame 201 is referred to as a first metal layer 201a, and a metal layer defining the inner surface thereof is referred to as a second metal layer 201b.

The coupling portion 210 and the antenna-attached portion 220 provided at the inner surface of the side frame 201 may be made of the same material as the second metal layer 201b. A forging process or CNC processing for forming the coupling portion 210 and the antenna-attached portion 220 may be performed selectively only for the second metal layer 201b. Accordingly, the coupling portion 210 and the antenna-attached portion 220 are made of the same material as the second metal layer 201 b. A method of forming the coupling portion 210 and the antenna-attached portion 220 by processing the second metal layer 201b will be described hereinafter.

Meanwhile, the bottom frame 202 is preferably made of the same material as the second metal layer 201b. As the coupling portion 210 is made of the same material as the second metal layer 201b, it is more suitable for coupling the two components when the bottom frame 202 is made of the same material as the coupling portion 210.

In one embodiment, the first metal layer 201a may be made of any one metal of titanium, copper, and stainless steel, and the second metal layer 201b may be made of any one metal of aluminum and magnesium. Here, the coupling portion 210 and the antenna-attached portion 220 may be made of the same metal as the second metal layer 201b.

According to the above-described structure, the outermost region (or area) and the rest of the region of the metal case are made of different metals. When comparing the two, the remaining region is relatively more processed. That is, the forging process or CNC processing is mainly performed on the remaining region. When the remaining region is made of a soft metal or low-cost metal, it is possible to facilitate processing, or to reduce costs of raw material wasted during processing.

Hereinafter, a method for manufacturing a metal case according to the present disclosure will be described.

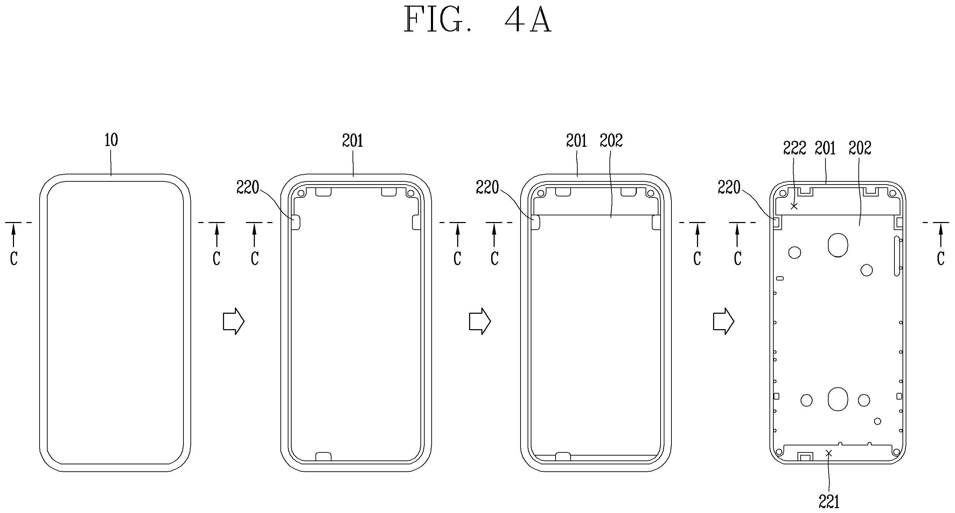

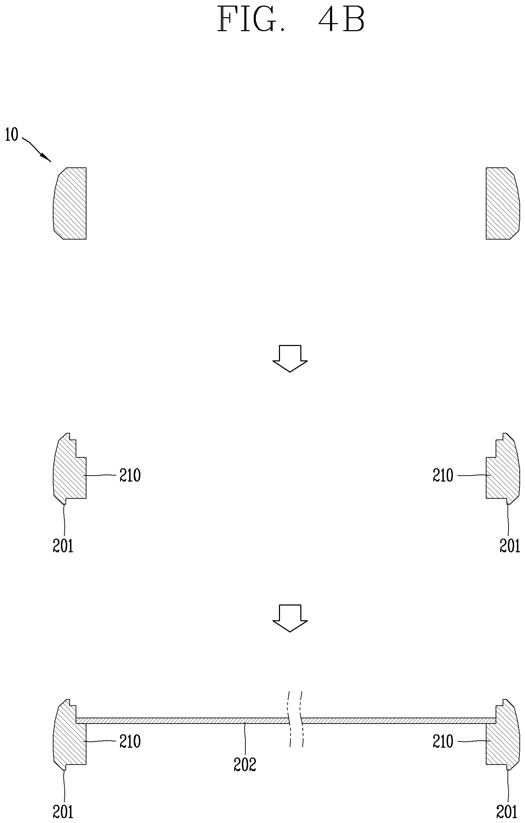

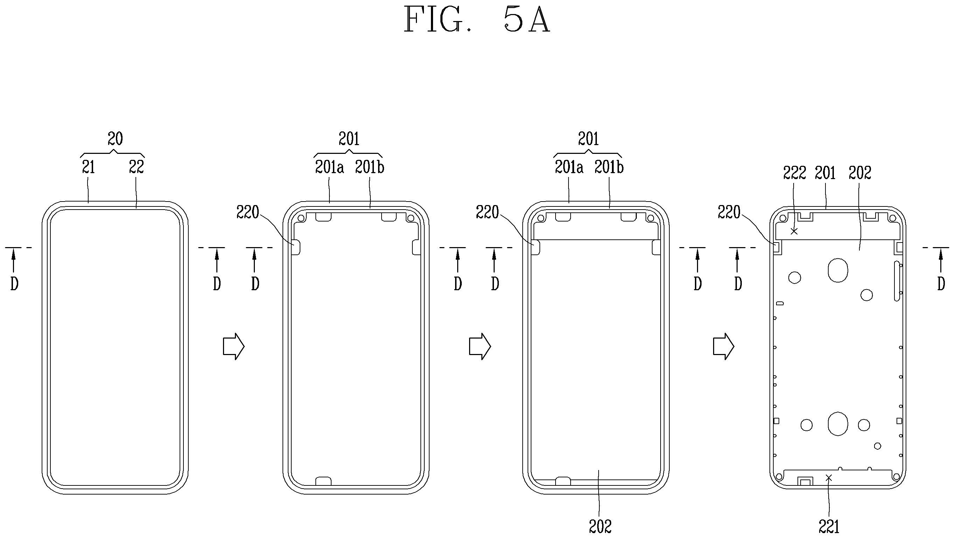

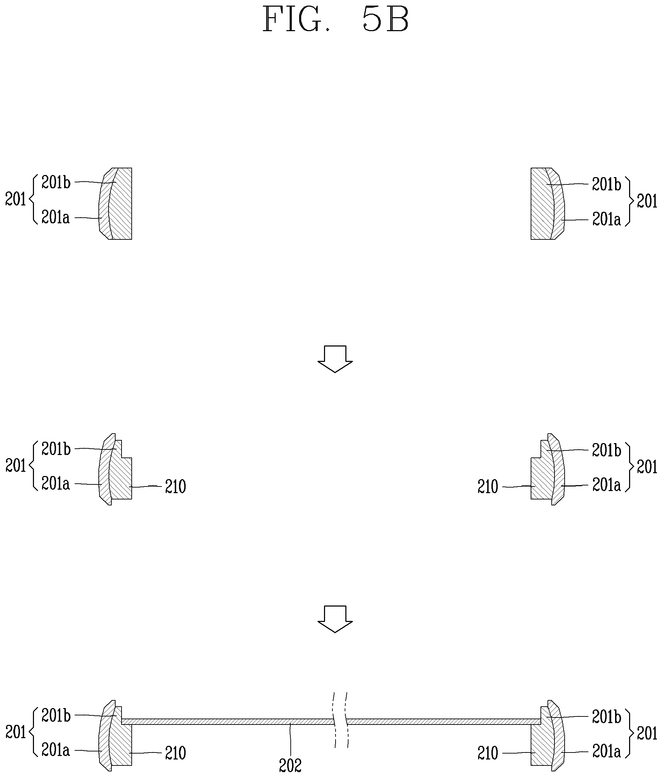

FIG. 4A is a schematic view illustrating a method for manufacturing a metal case according to the present disclosure, FIG. 4B is a cross-sectional view taken along line "C-C" of FIG. 4A, FIG. 5A is a schematic view illustrating a method for manufacturing a metal case from a raw material of clad metal, and FIG. 5B is a cross-sectional view taken along line "D-D" of FIG. 5A.

First, in the manufacturing method according to the present disclosure, the coupling portion 210 and the antenna-attached portion 220 are formed at a raw material 10 having a ring shape, as illustrated in the second picture of FIG. 4A and the second picture of FIG. 4B.

Here, the coupling portion 210 and the antenna-attached portion 220 may be formed by forging or CNC processing. In addition, an outer surface of the raw material 10 may be processed into a curved shape.

As illustrated in the third picture of FIG. 4A and the third picture of FIG. 4B, a metal sheet (bottom frame) 202 is coupled to the coupling portion 210. The metal sheet 202 and the coupling portion 210 may be joined together by welding or an adhesive material. Alternatively, the metal sheet 202 may be produced by insert die casting in a state that the side frame 201 is manufactured. In this case, the process of joining the side frame 201 and the metal sheet 202 together is not required.

Finally, after the metal sheet 202 is coupled to the coupling portion 210, the plurality of holes 221 and 222 is formed by CNC processing. The process of forming the holes is the same as the conventional hole formation process.

Meanwhile, the ring-shaped raw material may be a clad metal. In detail, a raw material 20 may have two metal layers 21 and 22 as illustrated in the first picture of FIG. 5A and the first picture of FIG. 5B.

Here, the coupling portion 210 and the antenna-attached portion 220 may be only formed at an inner surface. In other words, the process of forming a protruding portion (or protrusion) on the inner surface of the raw material 20 may be performed only on the second metal layer. More specifically, referring to the second picture of FIG. 5A and the second picture of FIG. 5B, the coupling portion 210 may extend from the second metal layer 201b. CNC processing may be performed on the first metal layer 201a, but this is a process or step for forming an outer appearance of the terminal.

After the metal sheet is coupled to the coupling portion 210, a plurality of holes is formed on the bottom frame 202 by CNC processing, as described in FIGS. 4A and 4B.

Meanwhile, the raw material may be manufactured from a metal sheet or clad metal.

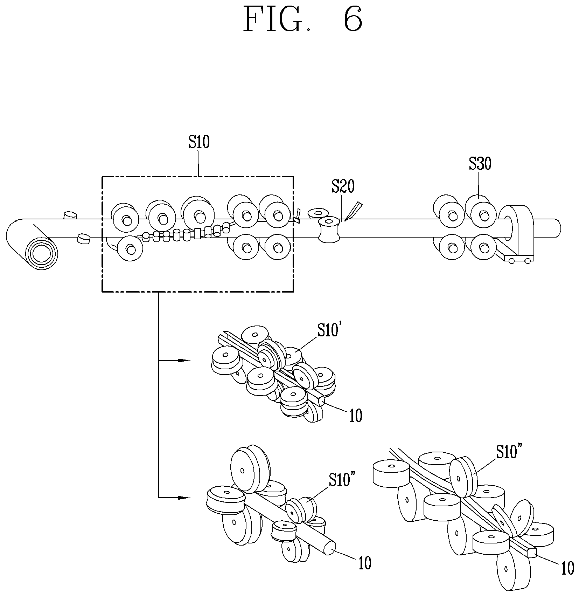

FIG. 6 is a schematic view illustrating a method for manufacturing a raw material having a ring shape from a metal sheet.

First, a step of metal sheet rolling is performed, as in S10. Here, a square pipe may be made straight from a metal sheet as illustrated in S10', or a circular pipe made from a metal sheet is processed to make a square pipe as illustrated in S10".

Then, welding and heat treatment are performed to make the metal sheet into a complete pipe (S20). Finally, the pipe is cut into a predetermined size (S30).

According to the manufacturing method of the present disclosure, CNC processing is performed only for forming the coupling portion and the antenna-attached portion at the side frame, and for forming the plurality of holes and opening portions on the bottom frame. Thus, a time taken to manufacture the metal case and manufacturing costs may be reduced compared to the related art metal case manufacturing method that only uses CNC processing.

Further, according to the present disclosure, as the CNC processing is selectively applied to the inner surface of the side frame and the bottom frame, a metal easy to process may be used for the inner surface of the side frame and the bottom frame, thereby ensuring easier processing of the metal case.

It will be apparent to those skilled in the art that the present disclosure may be embodied in other specific forms without departing from the spirit or essential characteristics thereof.

Therefore, it should also be understood that the above-described embodiments are not limited by any of the details of the foregoing description, unless otherwise specified, but rather should be construed broadly within its scope as defined in the appended claims, Therefore, all changes and modifications that fall within the metes and bounds of the claims, or equivalents of such metes and bounds are therefore intended to be embraced by the appended claims.

### INDUSTRIAL AVAILABILITY

The present disclosure may be variously used and applied in industrial fields of developing and manufacturing a mobile terminal having a metal case.

## Claims

1. A mobile terminal, comprising:
a terminal body having a display disposed on one surface thereof and provided with an antenna; and
a metal case defining an outer appearance of the terminal body and supporting an inside of the terminal body,
wherein the metal case comprises:
a side frame having a ring shape and defining a side surface of the terminal body; and
a bottom frame coupled to the side frame, supporting the display, and having a plurality of holes, and
wherein a coupling portion coupled to the bottom frame is provided at an inner surface of the side frame.

2. The mobile terminal of claim 1, wherein the side frame further comprises an antenna-attached portion protruding from the inner surface thereof and electrically connected to the antenna.

3. The mobile terminal of claim 2, wherein the inner surface and an outer surface of the side frame are made of different materials.

4. The mobile terminal of claim 3, wherein the side frame includes a first metal layer defining the outer surface thereof and a second metal layer defining the inner surface thereof and made of a different material from the first metal layer.

5. The mobile terminal of claim 4, wherein the antenna-attached portion protrudes from the second metal layer and is made of the same material as the second metal layer.

6. The mobile terminal of claim 5, wherein the coupling portion protrudes from the second metal layer and is made of the same material as the second metal layer.

7. The mobile terminal of claim 6, wherein the bottom frame is made of the same material as the second metal layer.

8. The mobile terminal of claim 4, wherein the first metal layer is made of any one of titanium, copper and stainless steel, and
wherein the second metal layer is made of any one of aluminum and magnesium.

9. A method for manufacturing a metal case, the method comprising:
forming a side frame by providing a coupling portion and an antenna-attached portion at an inner surface of a ring-shaped raw material made of a metal or alloy;
forming a bottom frame by coupling a metal sheet to the coupling portion; and
forming a plurality of holes by cutting the bottom frame,
wherein the side frame and the bottom frame are made of different materials.

10. The method of claim 9, wherein an inner surface and an outer surface of the side frame are made of different materials, and
wherein the inner surface of the side frame and the bottom frame are made of the same material.
